# EUROPÄISCHE PATENTSCHRIFT

(11) **EP 2 067 874 B1**
(45) Veröffentlichungstag und Bekanntmachung des Hinweises auf die Patenterteilung: **02.03.2011**
(21) Anmeldenummer: 08019797.3
(22) Anmeldetag: 12.11.2008
(51) Int. Cl.: C23C 14/34

(54) **Magnetische Shunts in Rohrtargets**
Magnetic shunts in tube targets
Shunts magnétiques dans des tuyaux cibles

(30) Priorität: 29.11.2007 DE 102007057870; 12.12.2007 DE 102007060306
(43) Veröffentlichungstag der Anmeldung: 10.06.2009
(73) Patentinhaber: W.C. Heraeus GmbH, 63450 Hanau (DE)
(72) Erfinder: Pavel, Hans-Joachim, 63526 Erlensee (DE); Heindel, Josef, 63512 Hainburg (DE)
(74) Vertreter: Kühn, Hans-Christian

(56) Entgegenhaltungen:
- DE-U1-202005 015 067
- JP-A- 2003 138 372
- US-A- 5 653 856

## Beschreibung

Die Erfindung betrifft ein Sputtertarget mit einem Trägerkörper und einem auf dem Trägerkörper angeordneten Targetmaterial, wobei der Trägerkörper eine dem Targetmaterial abgewandte rückseitige Oberfläche und das Targetmaterial eine dem Trägerkörper abgewandte vorderseitige Oberfläche aufweist.

Sputtertargets haben häufig den Nachteil, dass das Material ungleichmäßig abgesputtert wird, so dass an einigen Stellen des Sputtertargets das abzusputtemde Material bereits verbraucht ist, wenn an anderen Stellen noch genügend Sputtermaterial vorhanden ist. Dadurch wird das ursprünglich vorhandene Sputtermaterial häufig nicht optimal ausgenutzt. In der Praxis wird häufig versucht, durch eine NachjustIerung der In den Sputteranlagen vorhandenden Magnetsysteme oder durch Anbringen von Zusatzmagnetsystemen einen gleichmäßigeren Abtrag zu erzielen, um höhere Sputterraten zu erzielen. Solche Systeme sind beispielsweise in DE 103 36 422 A1 beschrieben. Einen anderen Weg geht EP 1 063 679 A1. Hier werden Blechstreifen unterhalb des Sputtertargets in das Magnetsystem integriert. Ähnliche Wege werden in DE 196 22 606 A1 beschrieben.

JP 2003138372 A beschreibt einen anderen Weg, die Sputterraten zu erhöhen. Hier wird die Dicke des Sputtermaterials über die Fläche des Sputtertargets variiert. Eine verringerte Dicke des Sputtermaterials ermöglicht die Durchdringung des Magnetfeldes durch das magnetische Sputtermaterial. Weitere planare Sputtertargets sind aus JP 1147063 A bekannt. Hier sind in die Grundplatte des Sputtertargets magnetische Streifen eingebettet, so dass ringförmige Abtragsmuster entstehen, wobei sich bei den dargestellten keilförmigen Targetplatten konzentrische Berge und Täler abwechseln.
Aus US-A-5653856 Sind Rohrtargets mit ferromagnetischem Material bekannt. DE 20 2005 015067 U1 offenbart Rohrtargets, bei denen ein homogener Materialabtrag erfolgt.

Aufgabe der vorliegenden Erfindung ist es, Sputtertargets, insbesondere Rohrtargets, bereitzustellen, die ein möglichst gleichmäßiges Abtragsverhalten aufweisen. Dazu soll in sehr einfacher Weise eine Beeinflussung des Magnetfeldes im Sputterprozess erfolgen.

Die Aufgabe wird erfindungsgemäß durch die Merkmale des Anspruchs 1 gelöst. Vorteilhafte Ausgestaltungen ergeben sich aus den abhängigen Ansprüchen. Dadurch, dass zwischen der vorderseitigen Oberfläche des Targetmaterials und der rückseitigen Oberfläche des Trägerkörpers ein ferromagnetisches Material angeordnet ist, wird das anlagenbedingt vorhandene Magnetfeld beeinflusst, so dass die Standzeit der Sputtertargets durch Reduzierung der sich ggf. ausbildenden Sputtergräben erhöht wird. Dadurch, dass der Trägerkörper als Trägerrohr ausgebildet ist und das Targetmaterial an der Außenseite des Trägerrohres angeordnet ist, ergeben sich Vorteile beim Sputtern. Dabei hat es sich überraschenderweise gezeigt, dass es möglich ist, selbst bei einer relativ kompliziert zu erstellenden rohrförmigen Struktur das Abtragsverhalten zu verbessern, ohne die Rohrkonstruktion selbst negativ zu beeinflussen.

Das ferromagnetische Material kann zweckmäßigerweise in oder an einem Zwischenraum zwischen Trägerkörper und Targetmaterial angeordnet sein. Es kann sich insbesondere in Richtung der größten Längserstreckung des Trägerkörpers außerhalb der Mitte der Längserstreckung befinden, so dass die Enden der Rohre oder die im Bereich der Enden der Rohre liegenden Sputterbereiche beeinflusst werden, Ein besonders vorteilhafter und gleichmäßiger Abtrag ergibt sich, wenn das ferromagnetische Material in einem Längsschnitt längs der größten Erstreckung des Trägerkörpers oberhalb der Grundlinie des ferromagnetischen Materials ein kantenloses Profil aufweist. Bei einer solchen Ausbildung des ferromagnetischen Materials verändert sich seine Dicke kontinuierlich und stetig, so dass das Magnetfeld ebenfalls stetig geändert wird und in der Folge ein gleichmäßiger Abtrag über die Oberfläche des Sputtermaterials gesehen erfolgt.

Das ferromagnetische Material kann insbesondere aufgespritzt sein. Hierzu bietet sich u.a. das Plasmaspritzen an. Besonders vorteilhaft ist die Verwendung des ferromagnetischen Materials in solchen Fällen, in denen das Targetmaterial selbst nicht ferromagnetisch ist. Das ferromagnetische Material kann in den Trägerkörper und/oder in das Targetmaterial eingebettet sein. Insbesondere kann das Trägermaterial auch dahingehend beeinflusst werden, dass es ferromagnetische Eigenschaften aufweist. In der Regel ist beispielsweise ein Trägerrohr aus Edelstahl gebildet. Es ist möglich, ein solches Trägerrohr einer Wärmbehandlung bis zur Phasenumwandlung zu unterziehen. Dafür sind Temperaturen vorn ; 900 °C notwendig. Der Erwärmung folgt eine schnelle Abkühlung, so dass der entstandene Phasenzustand praktisch eingefroren wird, so dass das Trägerrohr aus einem ferromagnetischen Edelstahl gebildet ist. Ebenso ist es möglich, in einem Trägerkörper aus einem Edelstahl begrenzte ferromagnetische Bereiche zu erzeugen, in dem beispielsweise das Material des Trägerkörpers, insbesondere des Trägerrohres, partiell aufgeschmolzen wird, beispielsweise durch ein SchweißverFahren, so dass partiell ferromagnetische Bereiche entstehen.

Nachfolgend wird ein Ausführungsbeispiel der Ereindung anhand einer Zeichnung näher erläutert. In der Zeichnung zeigt
- Fig. 1a: den Schnitt durch ein herkömmliches Sputtertarget, vor dem Sputtern,
- Fig. 1b: den Schnitt durch ein herkömmliches Sputtertarget, nach dem Sputtern, und
- Fig. 2: den Schnitt durch ein erfindungsgemäßes Sputtertarget.

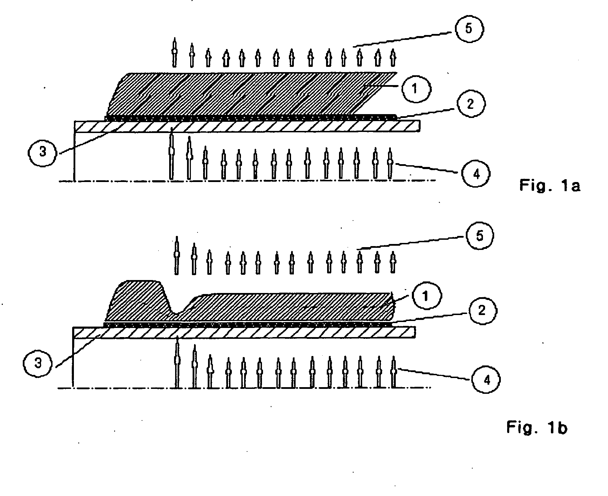

In Fig. 1a ist ein Teil eines rohrförmigen Sputtertargets dargestellt mit einem Targetmaterial 1, welches auf ein Trägerrohr 3 aufgebracht ist. Zwischen dem Targetmaterial 1 und dem Trägerrohr 3 ist eine Haftvermittlerschicht 2, z.B. eine Lotschicht, angeordnet, die das Targetmaterial 1 auf dem Trägerrohr 3 fixiert und die beide elektrisch und wärmeleitend miteinander verbindet. Die aus dem Inneren des Trägerrohres 3 einwirkenden Magnetfeldlinien 4 sind entsprechend dem beabsichtigten Abtrag des Targetmaterials 1 in ihrer Stärke längs des Sputtertargets justiert. Durch das Targetmaterial 1, die Haftvermittlerschicht 2 und das Trägerrohr 3 werden sie gedämpft, so dass das austretende Magnetfeld 5 eine geringere Stärke aufweist. Durch die unterschiedliche Stärke der Magnetfeldlinien 4 wird ein unterschiedlicher Sputterabtrag des Targetmaterials 1 bewirkt, so dass, wie in Fig. 1b dargestellt, sogenannte Sputtergräben entstehen können. Das Sputtertarget muss dadurch ausgetauscht werden, lange bevor das theoretisch abzusputternde Material verbraucht ist.

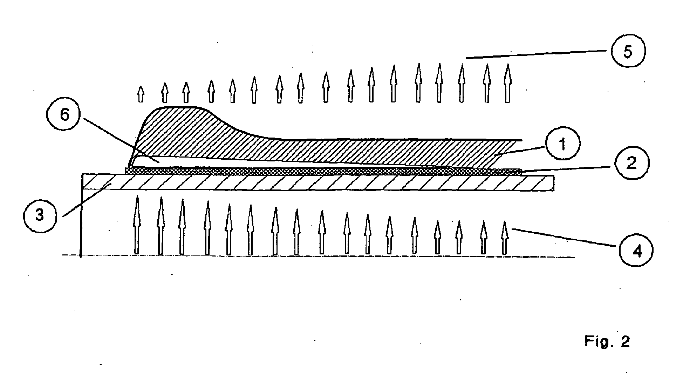

In Fig. 2 ist ein erfindungsgemäßes Sputtertarget nach dem Sputtervorgang dargestellt. Dabei ist zwischen dem Targetmaterial 1 und dem Trägerrohr 3 ein ferromagnetisches Material 6 eingebracht worden, das zu einer Vergleichmäßigung des Materialabtrages geführt hat. Im Endbereich des Targetmaterials 1, wo ein Abtrag in der Regel weniger gewünscht ist, ist das ferromagnetische Material 6 stärker ausgebildet, so dass der Magnetfeiddurchtritt behindert wird. Durch die stetige Ausbildung des ferrogmagnetischen Materials 6 ist ein gleichmäßiger Abtrag erzielt worden. Das ferromagnetische Material 6 wurde aufgespritzt, Als ferromagnetisches Material kann beispielsweise Nickel verwendet werden, wobei die Schichtdicke, die Dichte des Materials der Schicht und die Ausbildung der Schicht (magnetische Orientierung) dem beabsichtigten Erfolg angepasst werden kann, wobei sichergestellt werden sollte, dass ein Mindestmagnetfelddurchgriff bestehen bleibt. Die optimale Schichtdicke wird durch das Ferromagnetische Material 6 selbst, durch die Ausbildung der Schicht und durch die Dichte der Schicht beeinflusst. Die Schichtdicke weist, je nach beabsichtigtem Erfolg, einen Wert bis zu 2,5 mm auf. Das ferromagnetische Material 6 ist eingebettet zwischen Trägerrohr 3 und Targetmaterial 1. Es ist aufgespritzt worden. Durch das "Einbetten" des ferromagnetischen Materials 6 werden Querverunreinigungen während des Sputterprozesses vermieden, so dass der zu beschichtende Gegenstand nur mit dem Targetmaterial 1 selbst beschichtet wird. Das ferromagnetische Material 6 kann auch als Innenbeschichtung des Targetmaterials 1 (an der Innenseite des Rohres aus Targetmaterial 1) oder innerhalb des Targetmaterials 1 angeordnet sein. Dadurch ist es auch wirksam, wenn sogenannte monolithische Sputtertargets verwendet werden, also Stuttertargets, bei denen das Targetmaterial zugleich das Trägerrohr darstellt.
Alternativ zu einem aufgespritzten ferromagnetischen Material 6 ist es auch möglich, Folien oder Ringe auf das Trägerrohr 3 aufzubringen, vorzugsweise aufzulöten oder anzuschweißen. Ferromagnetisch aktive Schichten können auch in das Targetmaterial 1 selbst eingearbeitet werden, insbesondere an dessen Unterseite. Auch ein Anschweißen magnetisch aktiver Trägerrohrsegmente ist möglich, so dass das Trägerrohr 3 aus mehreren Segmenten besteht, von den einzelne ferromagnetisch sind, so dass lokal Änderungen der magnetischen Materialeigenschaften des Trägerrohres erfolgen. Das ferromagnetisch aktive Material 6 selbst kann beispielsweise Nickel, Eisen oder Kobalt sein.

Das Trägerrohr 3 weist in der Regel eine Wandstärke von 3 bis 6 mm auf, wobei Standardwandstärken bei 4 mm liegen. Die Erfindung kann bei Trägerrohren 3 aus praktisch allen geeigneten Materialen eingesetzt werden. Zu nennen sind hier beispielhaft Edelstahl, Kupfer, Aluminium oder Titan, gegebenenfalls unter Einschluß von ferromagnetischen Segmenten. Die Dicke des Targetmaterials 1 liegt beispielhaft im Bereich von 2 bis 20 mm. Eine Begrenzung der Dicke ist gegeben durch den Magnetfelddurchtritt der in der Sputteranlage eingesetzten Magnetsätze, durch den Herstellprozess und die Materialkosten,

Durch Beeinflussung des Magnetfeldes im Sputtertarget kann eine aufwendige Justierung der Sputteranlage bzw, der Magneten an der Sputteranlage vermieden werden bei gleichzeitiger Erhöhung der Materialausbeufe des Targetmaterials 1.

## Patentansprüche

1. Sputtertarget mit einem Trägerkörper und einem auf dem Trägerkörper angeordneten Targetmaterial, wobei der Trägerkörper eine dem Targetmaterial abgewandte rückseitige Oberfläche und das Targetmaterial eine dem Trägerkörper abgewandte vorderseitige Oberfläche aufweist, wobei zwischen der vorderseitigen Oberfläche und der rückseitigen Oberfläche ein ferromagnetisches Material angeordnet ist, **dadurch gekennzeichnet, dass** sich längs der größten Erstreckung des Trägerkörpers die Dicke des ferromagnetischen Materials kontinuierlich und stetig verändert, dass der Trägerkörper als Trägerrohr ausgebildet ist und dass das Targetmaterial an der Aussenseite des Trägerrohres angeordnet ist.

2. Sputtertarget nach Anspruch 1, **dadurch gekennzeichnet, dass** das ferromagnetische Material in oder an einem Zwischenraum zwischen Trägerkörper und Targetmaterial angeordnet ist.

3. Sputtertarget nach Anspruch 1 oder 2, **dadurch gekennzeichnet, dass** das ferromagnetische Material, in Richtung der großen Längserstreckung des Trägerkörpers, außerhalb der Mitte der Längserstreckung angeordnet ist.

4. Sputtertarget nach einem der Ansprüche 1 bis 3, **dadurch gekennzeichnet, dass** das ferromagnetische Material in einem Längsschnitt längs der größten Erstreckung des Trägerkörpers oberhalb der Grundlinie des ferromagnetischen Materials ein kantenloses Profil aufweist.

5. Sputtertarget nach einem der Ansprüche 1 bis 4, **dadurch gekennzeichnet, dass** das ferromagnetische Material aufgespritzt ist.

6. Sputtertarget nach einem der Ansprüche 1 bis 5, **dadurch gekennzeichnet, dass** das Targetmaterial nichtferromagnetisch ist.

7. Sputtertarget nach einem der Ansprüche 1 bis 6, **dadurch gekennzeichnet, dass** das ferromagnetische Material in dem Trägerkörper undloder dem Targetmaterial eingebettet ist.

8. Sputtertarget nach einem der Ansprüche 1 bis 7, **dadurch gekennzeichnet, dass** der Trägerkörper aus einem ferromagnetischen Edelstahl gebildet ist.

## Claims

1. Sputter target with a carrier body and a target material provided on the carrier body, the carrier body having a rear surface facing away from the target material and the target material having a front surface facing away from the carrier body, with a ferromagnetic material provided between the front surface and the rear surface, **characterized in that**, along the greatest extension of the carrier body, the thickness of the ferromagnetic material changes continuously and steadily, the carrier body is designed as a carrier tube, and the target material is provided on the outer side of the carrier tube.

2. Sputter target according to claim 1, **characterized in that** the ferromagnetic material is provided in or at a space between carrier body and target material.

3. Sputter target according to claim 1 or 2, **characterized in that** the ferromagnetic material is provided - in the direction of the greatest longitudinal extension of the carrier body - outside of the center of the longitudinal extension.

4. Sputter target according to any one of the claims 1 to 3, **characterized in that** the ferromagnetic material has an edgeless profile in a longitudinal section along the greatest extension of the carrier body above the base line of the ferromagnetic material.

5. Sputter target according to any one of the claims 1 to 4, **characterized in that** the ferromagnetic material is sprayed on.

6. Sputter target according to any one of the claims 1 to 5, **characterized in that** the target material is non-ferromagnetic.

7. Sputter target according to any one of the claims 1 to 6, **characterized in that** the ferromagnetic material is embedded in the carrier body and/or the target material.

8. Sputter target according to any one of the claims 1 to 7, **characterized in that** the carrier body is formed of a ferromagnetic special steel.

## Revendications

1. Cible de pulvérisation comprenant un corps de support et une matière cible disposée sur le corps de support, dans laquelle le corps de support présente une surface arrière détournée de la matière cible et la matière cible présente une surface avant détournée du corps de support, dans laquelle un matériau ferromagnétique est disposé entre la surface avant et la surface arrière, **caractérisée en ce que** l'épaisseur du matériau ferromagnétique varie en continu et de manière constante le long de l'étendue la plus grande du corps de support, que le corps de support est réalisé en tant que tuyau de support et que la matière cible est disposée sur le côté externe du tuyau de support.

2. Cible de pulvérisation selon la revendication 1, **caractérisée en ce que** le matériau ferromagnétique est disposé dans ou sur un espace intermédiaire entre corps de support et matière cible.

3. Cible de pulvérisation selon la revendication 1 ou 2, **caractérisée en ce que** le matériau ferromagnétique est disposé en dehors du milieu de l'étendue longitudinale en direction de l'étendue longitudinale la plus grande du corps de support.

4. Cible de pulvérisation selon l'une quelconque des revendications 1 à 3, **caractérisée en ce que** le matériau ferromagnétique présente un profil sans arête dans une coupe longitudinale le long de l'étendue la plus grande du corps de support au-dessus de la ligne de base du matériau ferromagnétique.

5. Cible de pulvérisation selon l'une quelconque des revendications 1 à 4, **caractérisée en ce que** le matériau ferromagnétique est appliqué au pistolet.

6. Cible de pulvérisation selon l'une quelconque des revendications 1 à 5, **caractérisée en ce que** la matière cible est non ferromagnétique.

7. Cible de pulvérisation selon l'une quelconque des revendications 1 à 6, **caractérisée en ce que** le matériau ferromagnétique est encastré dans le corps de support et/ou la matière cible.

8. Cible de pulvérisation selon l'une quelconque des revendications 1 à 7, **caractérisée en ce que** le corps de support est formé à partir d'un acier spécial ferromagnétique.
